(19) Europäisches Patentamt
European Patent Office
Office européen des brevets

(11) EP 1 274 293 A1

(12) # EUROPEAN PATENT APPLICATION
published in accordance with Art. 158(3) EPC

(43) Date of publication:
**08.01.2003 Bulletin 2003/02**

(21) Application number: **01982830.0**

(22) Date of filing: **16.11.2001**

(51) Int Cl.[7]: **H05K 9/00**

(86) International application number:
**PCT/JP01/10058**

(87) International publication number:
**WO 02/043459 (30.05.2002 Gazette 2002/22)**

(84) Designated Contracting States:
**AT BE CH CY DE DK ES FI FR GB GR IE IT LI LU MC NL PT SE TR**

(30) Priority: **21.11.2000 JP 2000354254**

(71) Applicant: **Sony Corporation**
**Tokyo 141-0001 (JP)**

(72) Inventors:
- **OKAYAMA, Katsumi, c/o SONY CORPORATION**
  **Tokyo 141-0001 (JP)**
- **TOYOTA, Junichi, c/o SONY CORPORATION**
  **Tokyo 141-0001 (JP)**
- **SUGIMOTO, S.**
  **Graduate School of Engi. Tohoku Univ.**
  **Sendai-shi, Miyagi 980-8579 (JP)**
- **INOMATA, K.**
  **Graduate School of Engi. Tohoku Univ.**
  **Sendai-shi, Miyagi 980-8579 (JP)**

(74) Representative: **Müller - Hoffmann & Partner**
**Patentanwälte,**
**Innere Wiener Strasse 17**
**81667 München (DE)**

(54) **RADIO-WAVE ABSORBER**

(57) The present invention is a radio wave absorber having a high absorption performance for an electromagnetic wave of a high frequency and made thinner. The radio wave absorber comprises one or more magnetic layers including a magnetic material having a micro organization structure whose particle diameter is controlled to 1 to 100 nm. A radio wave absorbing sheet (2) comprises one magnetic layer formed by preparing as such a magnetic material including Fe, Co and Ni, which are ferromagnetic elements, or a material including an alloy containing Mn, as powder, and dispersing this powder into polymeric material and the like, and it has a radio wave absorption performance for a relatively near electromagnetic field.

FIG. 2

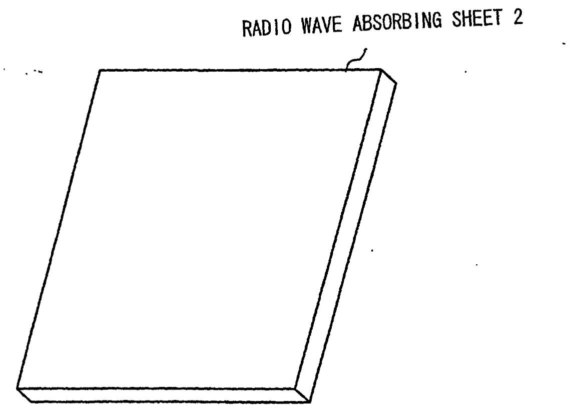


EP 1 274 293 A1

## Description

TECHNICAL FIELD

The present invention relates to a radio wave absorber for absorbing an unnecessary electromagnetic wave and, more particularly, to a thin radio wave absorber for absorbing an electromagnetic wave of a high frequency. In recent years, as a frequency of a signal used in an electronic apparatus has become higher, a problem of an unnecessary radiation emitted from the electronic apparatus has been remarked. Changing a circuit design, employing a counter-measure component and the like are considered as a method of suppressing the unnecessary radiation from the electronic apparatus. However, those methods become further difficult because of a demand for shorter period of a product span, an increase in cost and the like. For this reason, a method of using a counter-measure sheet or the like made up of a sheet shaped composite soft magnetic material having a magnetic loss even for an electromagnetic wave of a high frequency has been used.

Also, in recent years, a communication system using a high frequency radio wave, such as a wireless LAN (Local Area Network), an express highway automatic accounting system and the like has been developed. However, in an apparatus using a radio wave employed in these systems, any radio wave except a target signal electric wave results in a radio disturbance. Thus, development of a radio wave absorber has been desired for smooth communication by absorbing the generated radio disturbance. For example, electromagnetic waves in a frequency band of 2.45 GHz is used in various electronic apparatuses such as a microwave oven, a portable information terminal, a wireless LAN, Bluetooth and the like. It is important that those electronic apparatuses smoothly carry out communications without mutual malfunctions.

By the way, with regard to the unnecessary electromagnetic wave, it can be considered by classifying into a relatively near electromagnetic field and a far electromagnetic field; the former has a distance between a radio wave absorber and a wave source being less than $\lambda/6$ ($\lambda$: wavelength of electromagnetic wave) and the latter has the distance being lager than $\lambda/6$. The radio wave absorber for the near electromagnetic field converts the energy of an incident electromagnetic wave into a heat for absorption. However, a loss term $\varepsilon''$ of a relative permittivity of the radio wave absorber (an imaginary component of a complex relative permittivity) and a loss term $\mu''$ of a relative magnetic permeability (an imaginary component of a complex relative magnetic permeability) contribute to this energy conversion. When the electromagnetic wave is incident on a material having such a loss, energy of the electromagnetic wave is converted into heat for absorption on the basis of the following equation (1):

$$P = 1/2\omega\varepsilon_0\varepsilon''|E^2| + 1/2\ \omega\mu_0\mu''|H^2| \qquad (1)$$

In the equation (1), P represents radio wave absorption energy per unit volume [W/m$^3$], $\omega$ represents an angular frequency of an electromagnetic wave ($2\pi f$, f : frequency of electromagnetic wave), $\varepsilon_0$ represents a magnetic permeability of free space, $\varepsilon''$ represents an imaginary component of a complex relative permittivity (a dielectric loss), E represents an electric field strength of an electromagnetic wave externally applied, $\mu_0$ represents a magnetic permeability of free space, $\mu''$ represents an imaginary component of a complex relative magnetic permeability (a magnetic loss), and H represents a magnetic field strength of the electromagnetic wave externally applied.

From the equation (1), the material having the larger loss has the larger radio wave absorption capacity. However, in the material conventionally used as the radio wave absorber, the value $\mu''$ for the electromagnetic wave in a high frequency band of 1 GHz or more is about 10. It can not be said that such a material has sufficient absorbing performance.

On the other hand, with regard to the far electromagnetic field, it is not possible to completely absorb the energy of the electromagnetic wave and to convert the energy into heat in such an extent that an electromagnetic wave enters such a material only once. This is because on a front surface of the radio wave absorber, the electromagnetic wave is reflected due to difference in impedance between air and the radio wave absorber. For this reason, when a plane wave from a distance is absorbed, a radio wave absorber of an impedance matching type is used for matching a wave impedance and an input impedance to the radio wave absorber and attenuating reflection amount. The radio wave absorber of this impedance matching type backs a rear surface of a magnetic layer with a conductor, and absorbing the electromagnetic wave by controlling phases of a reflection wave on this boundary between the conductor and the radio wave absorber, and a reflection wave on the front surface of the radio wave absorber to cancel the reflection waves each other. Usually, the radio wave absorber of the impedance matching type frequently targets for a return loss of 20 dB, which is a value representing 99 % absorption of the energy of the electromagnetic wave.

In the radio wave absorber of the impedance matching type as mentioned above, a material constant is typically designed so as to satisfy the following equation (2), and a thickness of a radio wave absorbing layer is controlled to thereby attain the non-reflection at a target frequency.

$$1 = \sqrt{\frac{\mu}{\varepsilon}} \tanh\left(\frac{2\pi f d}{c} i\sqrt{\varepsilon\mu}\right) \quad \ldots\ldots (2)$$

Where, $i$ is an imaginary number unit, and $d$ is a thickness of a radio wave absorber.

Conventionally, a radio wave absorber of the impedance matching type for a high frequency band of 1 GHz or more uses an oxide-containing magnetic material, such as ferrite or the like, having a high electric resistance, in many cases. For example, rubber ferrite is widely used. Among the ferrites, a spinel type ferrite is widely used in the MHz band, and a hexagonal ferrite is widely used in the GHz band. In the radio wave absorber of the impedance matching type, determination of a constant of the material determines a matching frequency and a matching thickness. For example, when the rubber ferrite is used for an electromagnetic wave of 2.45 GHz, its thickness becomes about 1 cm on the basis of the equation (2). Conventionally, the radio wave absorber of this thickness has been used. Also, in the radio wave absorber having a single layer structure of a magnetic layer using Ba (Fe, Ti, $Mn)_{12}O_{12}$ type magnetic material, one of the hexagonal ferrites, its thickness becomes about 3 mm with regard to the electromagnetic wave in the vicinity of 5 GHz.

However, with the progress of miniaturization of the electronic apparatus, such as a portable information terminal, for example, there is a need for making the radio wave absorber thinner to reduce the proportion of a radio wave absorber size to the apparatus size. It is desired to develop a radio wave absorber that is made thinner and lighter, while keeping its absorption performance of the radio wave, by using a material having a higher relative magnetic permeability. Also, conventionally, as the materials used for the radio wave absorber of the impedance matching type, there are carbonyl iron and foam styrol carbon, and as a soft magnetic substance - resin composite, an Fe-Si containing material, an Fe-Si-Al containing material, an Fe-Si-B containing material, an electromagnetic stainless containing material and the like are used. However, even if any of them is used, it is impossible to make the thickness thinner while keeping the absorption performance.

Also, recently, a thin film material containing Co is known as a material having a high relative magnetic permeability enough to cover up to the high frequency band. As disclosed in Japanese Patent Application Laid Open No. Hei 10-241938, for example. According to this disclosure, the high magnetic permeability and the high electric resistance can be both attained in a Co-Ni-Al-O thin film or the like by adopting a granular structure composed of two of more kinds of micro structure such as micro magnetic particles having particle diameters controlled to about 4 to 7 nm, and a grain boundaries of extremely thin ceramic film surrounding them. However, in this case, the thin film material was manufactured as a thin film by using a sputtering apparatus, and it can not be a material actually usable as the radio wave absorber.

The present invention is proposed in view of the above mentioned circumstances. It is therefore an object of the present invention to provide a radio wave absorber having a high absorption performance for an electromagnetic wave of a high frequency and being made thinner.

## DISCLOSURE OF THE INVENTION

In order to solve the above-mentioned problems, the present invention provides, in a radio wave absorber for absorbing an unnecessary electromagnetic wave, the radio wave absorber characterized by comprising one or more magnetic layers including a magnetic material having a micro organization structure in which a particle diameter is controlled to 1 to 100 nm.

In such a radio wave absorber, since the magnetic material having the micro organization structure in which the particle diameter is controlled to 1 to 100 nm is used for the magnetic layer, it can have a high electric resistance and a high relative magnetic permeability for an electromagnetic wave of a high frequency, and its absorption performance can be made higher and it can be made thinner and lighter. Also, it is configured such that a conductor is adhered on a surface opposite to an incident surface of the electromagnetic wave in this magnetic layer. Thus, a thin radio wave absorber of an impedance matching type can be configured for a relatively far electromagnetic field away from a wave source by λ/6 or more. Moreover, this magnetic layer is formed by dispersing powder made of magnetic material including any of a material containing one or more of Fe, Co and Ni or an alloy containing Mn, into polymeric material. Thus, it will be possible to provide a radio wave absorber more freely in its shape , such as a sheet, a paste, an injection molding product and the likeand also possible to reduce a manufacturing cost.

## BRIEF DESCRIPTION OF THE DRAWINGS

Fig. 1 shows a diagrammatic view of a magnetic material used in the present invention;

Fig. 2 is a view showing a structure of a radio wave absorbing sheet for a near electromagnetic field;

Fig. 3 shows a cross sectional view of a radio wave absorbing sheet for a far electromagnetic field;

Fig. 4 shows a cross sectional view of a radio wave absorbing sheet having a multi-layer structure for the far electromagnetic field;

Fig. 5 is a view showing radio wave absorption characteristics based on a design example of the radio wave absorbing sheet;

Fig. 6 is a view showing absorption characteristics for each frequency based on the design example of the electric wave absorbing sheet;

Fig. 7 is a view showing an application example to a portable telephone of an SAR suppresser of the present invention;

Fig. 8 is a view diagrammatically showing an application example as a cavity resonance suppresser of the present invention; and

Fig. 9 is a view showing a structure of a pyramidal radio wave absorber.

BEST MODE FOR CARRYING OUT THE INVENTION

An embodiment of the present invention will be described below with reference to the drawings.

Fig. 1 shows a diagrammatic view of a magnetic material used in the present invention.

In a magnetic material 1 shown in Fig. 1, a situation that micro magnetic particles 1a whose particle diameters are controlled to 1 to 100 nm are in slight contact with each other through a very thin particle boundary 1b is diagrammatically shown. As mentioned above, in the radio wave absorber, the material having the larger loss has the larger absorption capacity. For this reason, the material used in the present invention needs to have high relative magnetic permeability enough to cover up to a high frequency region. When a magnetic field of a high frequency is applied to the magnetic material 1, if the magnetic particles 1 are in contact with each other, a magnetic flux is passed through the region of the magnetic material 1. Thus, its relative magnetic permeability becomes higher. However, if the magnetic particles 1 are completely in series with each other, the electric resistance is decreased, which induces a current inside a magnetic body and generates an eddy current loss and thereby decreases the relative magnetic permeability. For this reason, the radio wave absorber of the present invention is designed such that although the magnetic materials 1 are in slight contact with each other, the very thin particle boundary 1b made of the compound of a high resistance is placed between the magnetic particles 1a to thereby obtain the material which has the high relative magnetic permeability enough to cover up to the high frequency band and has high loss. However, if the particle boundary 1b is excessively thick so that the magnetic particle 1a is isolated alone, there may occur a super paramagnetic property.

The guideline for obtaining high relative magnetic permeability even in the high frequency band is typically said as follows:

- Large saturation magnetic flux density.
- High electric resistance.
- Small magnetostriction.

In order to satisfy such conditions, a material containing one or more of Fe, Co and Ni that are ferromagnetic elements, or a material of an alloy containing Mn, such as MnAl, $Cu_2MnAl$, MnBi and the like are used. Moreover, a nano-granular structure having the micro organization structure composed of the magnetic micro particles whose particle diameters of this material are controlled to about 1 to 100 nm and the particle boundary made of high resistance substances such as ceramics of $Al_2O_3$ and the like surrounding the magnetic micro particles through deposition and the like is kept to thereby enable obtainment of the magnetic material in which the relative magnetic permeability, especially, μ" is high. As a metallic material used for such a magnetic material, for example, an FeCo containing material that is a material having a high saturation magnetic flux density is suitable.

An example of the radio wave absorber for the near electromagnetic field will be described below. Fig. 2 shows the structure of a radio wave absorbing sheet for the near electromagnetic field.

A radio wave absorbing sheet 2 shown in Fig. 2 is formed such that a magnetic layer containing the above mentioned magnetic material is shaped into a sheet in order to absorb electromagnetic wave in a relatively near electromagnetic field whose distance from a wave source is shorter than λ/6. As mentioned above, for the nearelectromagnetic field, the energy of the electromagnetic wave is converted into heat. The loss term ε" of the relative permittivity of the radio wave absorber and the loss term μ" of the relative magnetic permeability are related to this energy conversion. In a case of an electromagnetic wave incident to the material having such loss, the energy of the electromagnetic wave is converted into heat and absorbed on the basis of the above mentioned equation (1). According to this equation (1), in the absorption of the electromagnetic wave in which the μ" implying the magnetic loss is used, the absorption amount is increased in a case where a magnetic field strength H is stronger. For this reason, it is desired to install the radio wave absorber at a position as close as possible to the wave source.

In forming the radio wave absorbing sheet 2 shown in Fig. 2, for example, a method is used in which the above mentioned magnetic material is made into powder, and is compounded with a polymeric material to have a sheet. The magnetic material having the above mentioned nano-granular structure is prepared as powder material. It is appropriate that a diameter of the particle is 10 to 50 μm in view of filling into the powder. Also, a thickness of the grain boundary is desired to be equal to or less than a skin depth. Since the skin depth is about 1 μm, the thickness of the grain boundary is set to about 0.1 to 3 μm. That is, an aspect ratio is about 50/0.1=500 at maximum, and it is about 3/10=0.3 at minimum. Such powder material is dispersed into the polymeric material at a rate of a volume filling rate of 30 to 60 %, and it is kneaded by a three-roll mill to thereby generate a paste-like sample. Then, the sample is adjusted to have a predetermined thickness by a doctor blade method, and it is processed to be a sheet. As the polymeric material, it is possible to use chlorinated polyethylene, rubber type material, ABS resin, poly-lactic-acid having biodegradability and the like. Also, thermosetting resin, photo-curable resin and the like may be used to be cured. Moreover, concrete, ceramics and the like may be used instead of the polymer.

An example of the radio wave absorber for the far electromagnetic field will be described below. Fig. 3 shows a cross sectional view of the radio wave absorbing sheet for the far electromagnetic field.

As mentioned above, the radio wave absorber of the impedance matching type is used for the plane wave in the relatively far electromagnetic field whose distance from the wave source is λ/6 (λ: wave length of electromagnetic wave) or more. In such a radio wave absorber of the impedance matching type, non-reflection at a target frequency can be attained by designing a material constant to satisfy the above mentioned equation (2), and further controlling a thickness of a radio wave absorbing layer. A radio wave absorbing sheet 3 shown in Fig. 3 is a radio wave absorber of the impedance matching type, and it has a structure having a magnetic layer 31 and a conductor 32 adhered on a surface opposite to an incident surface of the electromagnetic wave of this magnetic layer 31. The material used to form the magnetic layer 31 and the generating method are similar to the case of the magnetic layer of the above mentioned radio wave absorbing sheet 2. Also, as the conductor 32 backed on the magnetic layer 31, it is possible to use a metallic film such as aluminum foil, carbon film, ITO film and the like. These materials may be generated as an evaporated film and a sputter film. Moreover, the metallic surface of the structure on which this radio wave absorbing sheet 3 is placed may be configured so as to correspond to this backed conductor.

Also, there may be a case where a radio wave absorber having a multi-layer structure containing the magnetic layer made of the above mentioned material is used as the radio wave absorber of the impedance matching type. Fig. 4 shows a cross sectional view of the radio wave absorbing sheet having the multi-layer structure for the far electromagnetic field.

A radio wave absorbing sheet 4 shown in Fig. 4 is configured such that a dielectric layer 41 using a dielectric material and a magnetic layer 42 are laminated from an incident surface side of an electromagnetic wave as a radio wave absorbing layer, and a conductor 43 is backed thereon. In this radio wave absorbing sheet 4, the magnetic layer 42 having a high relative magnetic permeability is formed on the side of the backed conductor 43, and the dielectric layer 41 is formed on the incident surface side of the electromagnetic wave. Accordingly, an impedance of the incident surface is made close to a space impedance so that a reflection amount is suppressed to thereby lead to an easy matching between phases of reflection waves. The dielectric layer 41 is formed by dispersing the dielectric material into a polymeric base material. As this dielectric material, it is possible to use ceramics, such as ceramics of $BaO$-$TiO_2$, $PbTiO_3$-$PbZrO_3$ (PZT), $PbO_2$-$Li_2O_3$-$ZrO_2$-$TiO_2$ (PLTZ s), $MgTiO_3$-$CaTiO_3$, $BaMg_{1-x}Ta_xO_3$, $BZn_{1-x}Ta_xO_3$, $Ba_2TiO_2$, $Zr_{1-x}Sn_xTiO_4$, $BaO$-$Nd_2O_3$-$TiO_2$, $Pb_{1-x}Ca_xZrO_3$, $PbTiO_3$-$PrZrO_3$-$PbB_{1(1-x)}B_{2(x)}O_3$, and the like. By the way, the structure of the radio wave absorbing sheet of the multi-layer structure is not limited to this. It is possible to design the structure to have a plurality of magnetic layers or dielectric layers formed therein.

Here, a design example of the radio wave absorbing sheet 4 having the structure as shown in Fig. 4 is illustrated. Also, Fig. 5 shows radio wave absorption characteristic based on this design example.

Here, the dielectric layer 41 is set to have a thickness of 200 μm; a real part ε' and an imaginary part ε" of a complex relative permittivity of 100 and 0.2, respectively; and a real part μ' and an imaginary part μ" of a complex relative magnetic permeability of 1, respectively. Also, the magnetic layer 42 is set to have a thickness of 200 μm, and a real part ε' and an imaginary part ε" of a complex relative permittivity of 110 and 0.2, respectively. In Fig. 4, a return loss of a case where the complex relative magnetic permeability of the magnetic layer 42 is changed is plotted, as the reflection property resulting from such a material. From Fig. 5, it can be ascertained that the usage of the material having a value close to a relative magnetic permeability of μ=40-30j enables a good absorption property of -20 dB or more to be obtained for an electromagnetic wave in a 2.2 GHz band.

Next, Fig. 6 shows absorption characteristics for each frequency, according to the above mentioned design example.

As the magnetic material having the values of the relative permittivity and the relative magnetic permeability such as the above mentioned design example, it is possible to use the FeCo containing material having a nano-granular organization. In Fig. 6, the return loss in a free space when the frequency of the electromagnetic wave is changed is measured for the radio wave absorbing sheet 4 of the impedance matching type having the multi-layer structure in which such a magnetic material is used for the magnetic layer 42, and the dielectric layer 41 and the magnetic layer 42 have the values indicated in the design example. As a result, a high absorption performance of -25 dB is indicated at a frequency of 2.2 GHz. Moreover, even in a peripheral band with this 2.2 GHz as a center, good absorption performances are indicated such as -20 dB in a band of 2.1 to 2.2 GHz and -10 dB in a band of 1.6 to 2.5 GHz.

As mentioned above, in the present invention, the magnetic material in which the particle diameter is controlled to be 1 to 100 nm to thereby generate the micro organization configuration is used for the magnetic layer. Thus, it is possible to manufacture the radio wave absorber having the good absorption performance for the electromagnetic wave of the high frequency in spite of being a thin type whose thickness is 1 mm or less. The usage of such a radio wave absorber enables the effective absorption of the unnecessary electromagnetic wave under narrow space, as compared with the conventional technique, and also enables the weight of the apparatus to be lighter. For example, the radio wave absorbing sheet 2 shown in Fig. 2 can be placed and used in the inner portions, such as rear sides of bodies of various electronic apparatuses and the like, for prevention of unnecessary radiation. Also, it can be used as a prepreg used to stick substrates together. Consequently, it is possible to effectively carry out a measure for preventing the unnecessary radiation under a light weight and space saving condition. Moreover, this also has an attenuation effect with regard to a conduction noise.

Also, in recent years, as a standard of an absorption amount through a human body for an electromagnetic wave emitted from electronic apparatus, a SAR (Specific Absorption Rate) being a local absorption power of an electromagnetic wave per weight of 1 kg is defined. As an applicable condition of an SAR suppresser for suppressing such an electromagnetic wave, it is required that a value of an imaginary part $\mu''$ of a complex relative magnetic permeability is high and that a value of tan $\delta$ ($\delta=\mu''/\mu'$) is large. Since the radio wave absorber of the present invention has a high $\mu''$, it is expected to be effective as the SAR suppresser.

Fig. 7 shows an application example of the SAR suppresser to a portable telephone. Fig. 7 shows a cross sectional side view. This portable telephone 7 is provided with: a circuit substrate 72 on which radio circuit units 71 are mounted; a conductive shield case 73 for accommodating them; an antenna 74 connected to the circuit substrate 72; a liquid crystal display unit 75; a keypad 76 for input; an outer casing 77 made of a plastic material and the like; and other members. In the portable telephone 7, suppressing a surface current flowing on the shield case 73 is effective for suppression of the SAR. So, a soft magnetic sheet 78 formed by mixing the magnetic material having the nano-granular organization and polymeric material and the like similarly to the radio wave absorbing sheet 2 shown in Fig. 2 was placed on the upper portion of the shield case 73. In this soft magnetic sheet 78, the FeCo containing material is used as the magnetic material, and polyvinyl chloride is used as a base material, and its size was defined as $10\times10\times2$ (mm). As a result of a measurement of this portable telephone 7, the value of the SAR was reduced by about 30 %, and there was not a substantial change in a gain of the antenna 74. That is, the soft magnetic sheet 78 functions as the SAR suppresser having the good performance for suppressing only the SAR without any interference with the property of the antenna 74.

Also, the radio wave absorber of the present invention is effective even for the suppression of the cavity resonance, in which the resonance in the outer casing and the like is caused by the electromagnetic wave emitted from inside the electronic apparatus, such as the circuit substrate and the like, since the magnetic loss of the radio wave absorber of the present invention is high.

Fig. 8 diagrammatically shows an application example as a cavity resonance suppresser. An casing body 81 shown in Fig. 8 accommodates, for example, a computer apparatus such as a personal computer and the like, a video camera and the like, and it is made of plastic, plated plastic , or Al, Mg and the like. In this casing 81, for example, a soft magnetic sheet 82 formed by mixing the magnetic material having the nano-granular organization and polymeric material and the like similarly to the radio wave absorber 3 shown in Fig. 3 is stuck on an inner surface so that the soft magnetic sheet 82 functions as the cavity resonance suppresser. As this soft magnetic sheet 82, for example, it is possible to obtain a good absorption performance for an electromagnetic wave having a frequency of about 30 MHz to 2.5 GHz when a thickness is about 0.3 to 2 mm. In this way, when the cavity resonance suppresser is placed on the outer casing 81 or the like, although a relatively wide area is required for placing the sheet, the soft magnetic sheet 82 can be made thinner than the conventional sheet. Thus, the weight of the outer casing 81 can be made lighter.

By the way, in the above mentioned radio wave absorbers, the sheet-like example has been described. However, the radio wave absorber using the above mentioned magnetic material is not limited to such an implementation. Various implementations can be designed depending on apparatuses to which the present invention is applied. For example, the material to form the magnetic layer may be prepared as a paste.

In order to obtain the paste material, for example, the powder made of the magnetic material having the nano-granular organization is prepared. Then this powder is kneaded with the material made of thermoplastic resin (thermosetting resin), photo curable resin, ultraviolet curable resin, room temperature curable resin or the like. At this time, depending on the kind of the resin, there may be a case that IPA (Isopropyl Alcohol) or another organic solvent is used as the solvent. It is generated such that the volume filling rate of the magnetic powder is adjusted to 20 to 50 % so as not to lose the fluidity. Also, when it is generated to have a high fluidity, the magnetic layer may be formed by a method of spraying the magnetic material onto a surface of a target object with a sprayer, by a coating method of coating with a brush or the like, or by a method of an injection molding and the like. Consequently, the radio wave absorber having the good absorption performance for the electromagnetic wave of the high frequency can be easily formed in various shapes, depending on the installing method.

As an application example of the radio wave absorber made of such a paste-like material, a pyramidal radio wave absorber which is used for a radio wave darkroom and the like is exemplified. Fig. 9 shows the structure of the pyramidal radio wave absorber. In this pyramidal radio wave absorber 9, a magnetic layers 92 having a plurality of cubically pyramidal shapes are formed on a surface of a conductor, such as a copper plate 91 provided on a wall surface and the like. Consequently, the radio wave absorber of the impedance matching type is formed. This magnetic layer 92 is formed by injection molding using the paste-like material generated by the above mentioned method. In such a pyramidal radio wave absorber 9, it can be considered that the absorption characteristic is gradually changed from a peak to a bottom of the pyramidal shape because of its shape. Thus, it has the absorption performance for the electromagnetic wave in a wide frequency range. However, the usage of the above mentioned material as the magnetic layer enables the good absorption performance to be given to even the electromagnetic wave of a higher frequency. Incidentally, in the pyramidal radio wave absorber 9, the pyramidal shape of the magnetic layer 92 is not only limited to the shape of the quadrangular pyramid shown in Fig. 9. but also it can be applied to a circular cone, a comb-like shape and the like.

Also, this paste-like material can be inserted into a dispenser and used as a sealing resin for IC and the like. In particular, when it is used as the sealing resin in a high frequency module, this provides an effect of preventing a mutual interference between an RF (Radio Frequency) signal and a BB (Base Band) signal. Also, when it is used as the mold sealing resin and the semiconductor sealing resin in an IC package, a magnetic particle is required to have high resistance. Thus, a surface of a particle is coated with oxide such as $Al_2O_3$ and the like, or high resistance resin such as acryl and the like, then this particle is filled at a volume rate of 30 to 50 % in the sealing resin or the mold resin such as epoxy resin and the like, and the sealing resin is generated by a method of an injection molding, a potting or the like. For example, when a thickness of the formed sealing resin is about 0.5 to 2 mm, the absorption performance can be obtained for an electromagnetic wave having a frequency of about 30 MHz to 2.5 GHz. In this way, the usage of the paste-like material enables the electric wave absorbing function to be given to the mold sealing resin or the sealing resin of the semiconductor. Thus, it is not necessary to have an extra space for installing a radio wave absorber around the semiconductor. Hence, the apparatus can be miniaturized, the manufacturing cost thereof can be hold down.

Moreover, in the outer casing 81 shown in Fig. 8, the soft magnetic sheet 82 is formed as the cavity resonance suppresser. However, it will be possible to make the cavity resonance suppresser by coating with the paste-like materials on a necessary surface of the outer casing 81, or by forming the outer casing 81 itself through the injection molding of the magnetic material having the nano-granular organization kneaded into the polymeric material constituting the outer casing 81 or other method. Especially in the latter method, the outer casing 81 itself can be used as the cavity resonance suppresser. Thus, a later counter-measure for the unnecessary electromagnetic wave during steps of manufacturing the apparatus can be simplified to thereby reduce the manufacturing cost and also miniaturize the apparatus. In addition, the usage of the above mentioned material can attain a radio wave absorbing substrate, a radio wave absorbing paste and the like, in which the product itself has the radio wave absorption performance. Also, a radio wave absorbing glass can be manufactured by mixing the magnetic material into transparent resin material while adjusting it so as to keep the transparency.

INDUSTRIAL APPLICABILITY

As described above, in the radio wave absorber of the present invention, the magnetic material having the micro organization structure in which the particle diameter is controlled to 1 to 100 nm is used as the magnetic layer. Thus, it becomes possible for the radio wave absorber to have the high electric resistance and the high relative magnetic permeability for the electromagnetic wave of the high frequency, to have increased absorption performance, and to be made thinner and lighter. Also, it is configured such that the conductor is adhered on the surface opposite to the incident surface of the electromagnetic wave in this magnetic layer. Hence, the thin radio wave absorber of the impedance matching type can be configured for the relatively far electromagnetic field at a distance not less than $\lambda/6$ from the wave source. Moreover, this magnetic layer is formed by dispersing the powder of the magnetic material including any of the material containing one or more of Fe, Co and Ni, and the alloy containing Mn, into the polymeric material. Consequently, it will be possible to provide a radio wave absorber more freely in its shape , such as a sheet, paste, an injection molding product and the like, and also possible to hold a manufacturing cost down.

**Claims**

1. In a radio wave absorber for absorbing an unnecessary electromagnetic wave, said radio wave absorber **characterized by** comprising one or more magnetic layers containing a magnetic material having a micro organization structure in which a particle diameter is controlled to 1 to 100 nm.

2. The radio wave absorber according to claim 1, **characterized in that** a conductor is adhered on a surface opposite to an incident surface of said electromagnetic wave in said magnetic layer.

3. The radio wave absorber according to claim 1, **characterized in that** said magnetic material includes any of a material containing one or more of Fe, Co and Ni and an alloy containing Mn.

4. The radio wave absorber according to claim 1, **characterized in that** said magnetic layer is formed by dispersing said magnetic material made into powder, into any of polymeric material, concrete and ceramics.

5. Theradio wave absorber according to claim 4, **characterized in that** said magnetic layer is formed by injection molding.

6. The radio wave absorber according to claim 4, **characterized in that** said magnetic layer is formed by coating.

7. The radio wave absorber according to claim 1, **characterized in that** a dielectric layer including a dielectric material is formed on an incident surface side of said electromagnetic wave in said magnetic layer.

8. An SAR suppresser **characterized by** comprising the radio wave absorber according to claim 1.

9. A cavity resonance suppresser **characterized by** comprising the radio wave absorber according to claim 1.

10. A radio wave absorbing case **characterized by** comprising the radio wave absorber according to claim 1.

11. A radio wave absorbing substrate **characterized in that** it is constituted by the radio wave absorber according to claim 1.

12. A radio wave absorbing paste **characterized by** composing the radio wave absorber according to claim 1.

13. A radio wave absorbing glass **characterized by** comprising the radio wave absorber according to claim 1.

FIG. 1

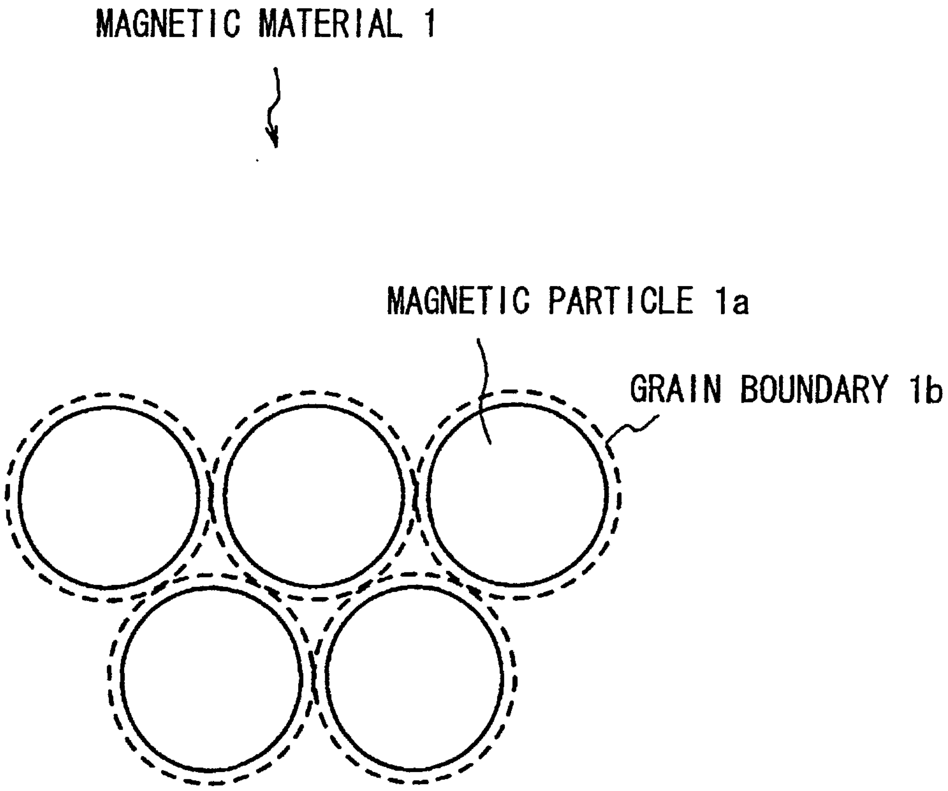
MAGNETIC MATERIAL 1
MAGNETIC PARTICLE 1a
GRAIN BOUNDARY 1b

FIG. 2

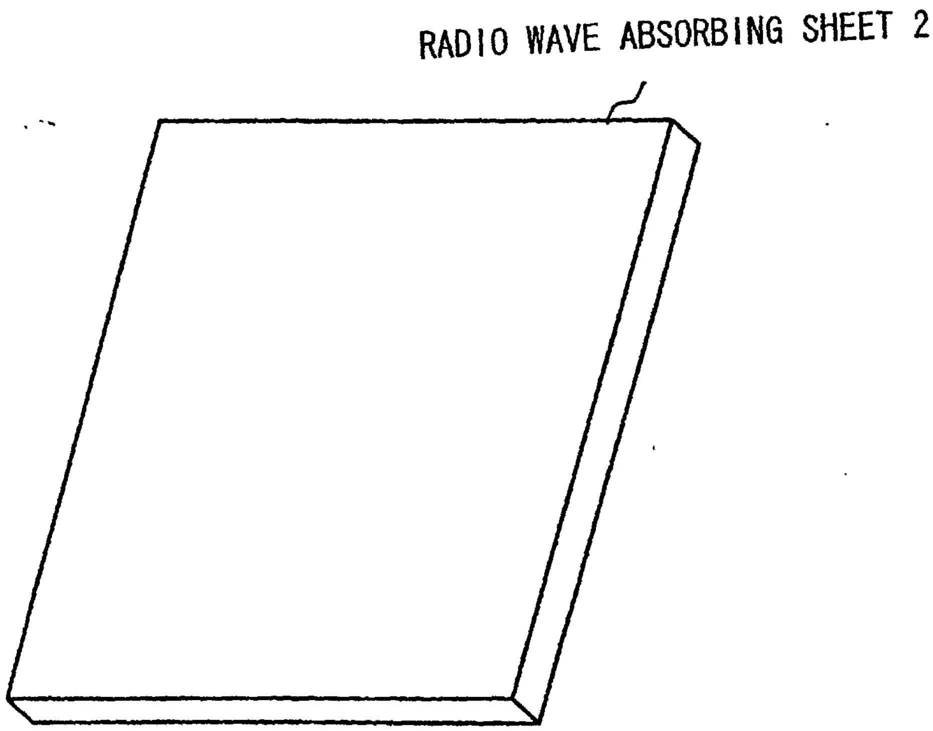

FIG. 3

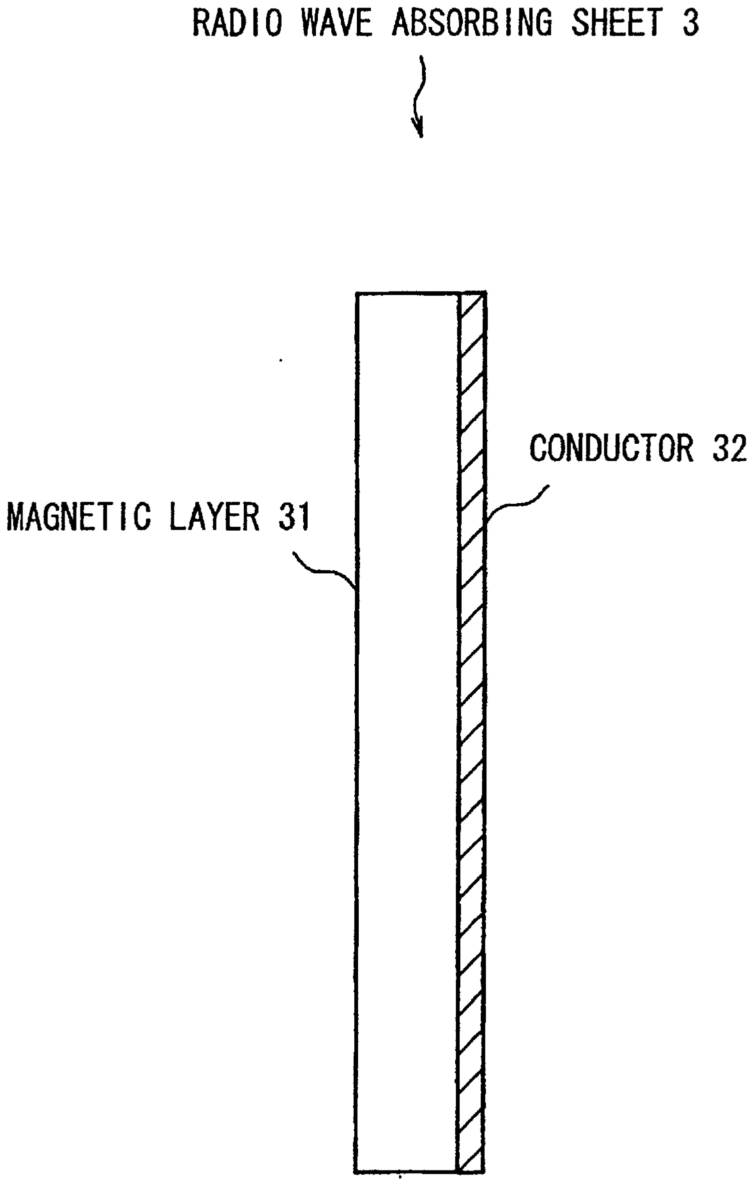
RADIO WAVE ABSORBING SHEET 3
CONDUCTOR 32
MAGNETIC LAYER 31

FIG. 4

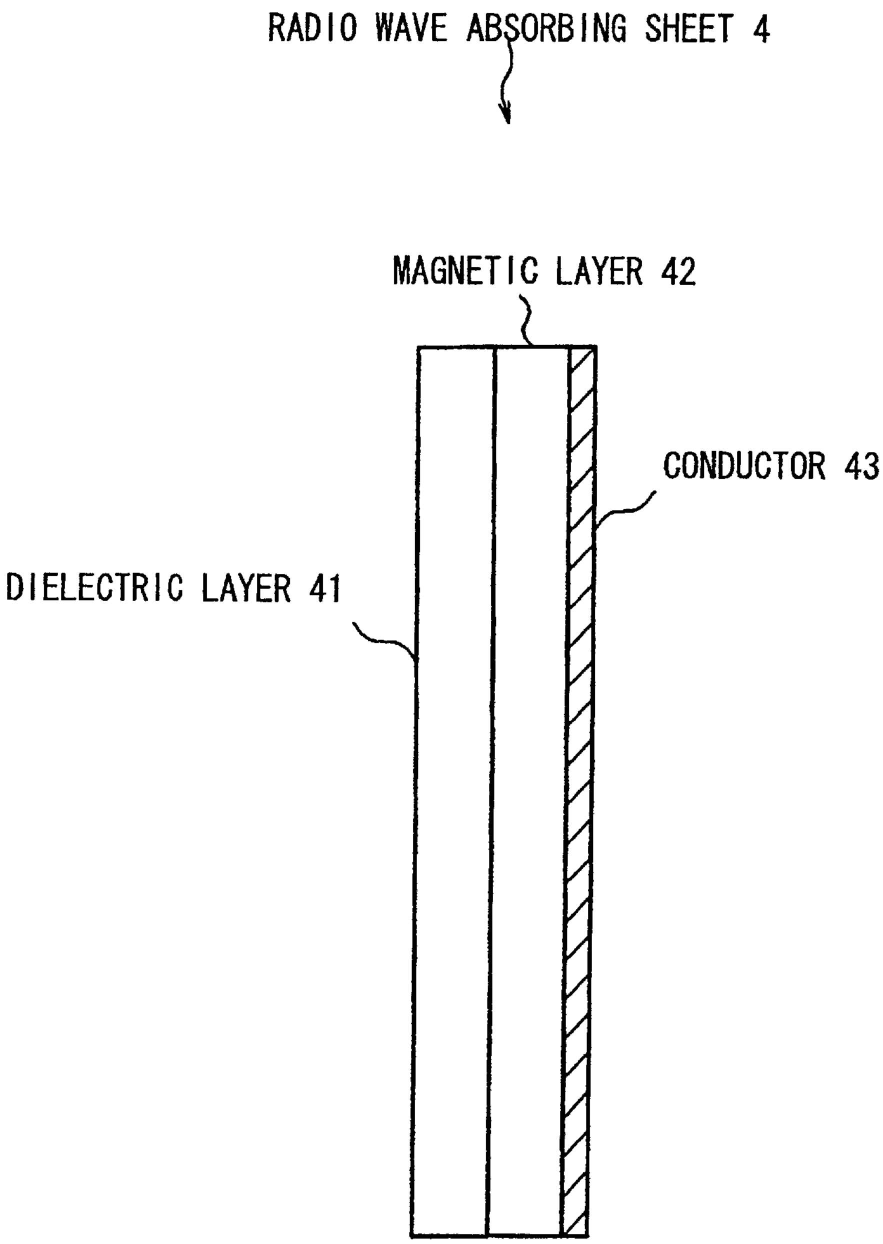
RADIO WAVE ABSORBING SHEET 4
MAGNETIC LAYER 42
CONDUCTOR 43
DIELECTRIC LAYER 41

FIG. 5

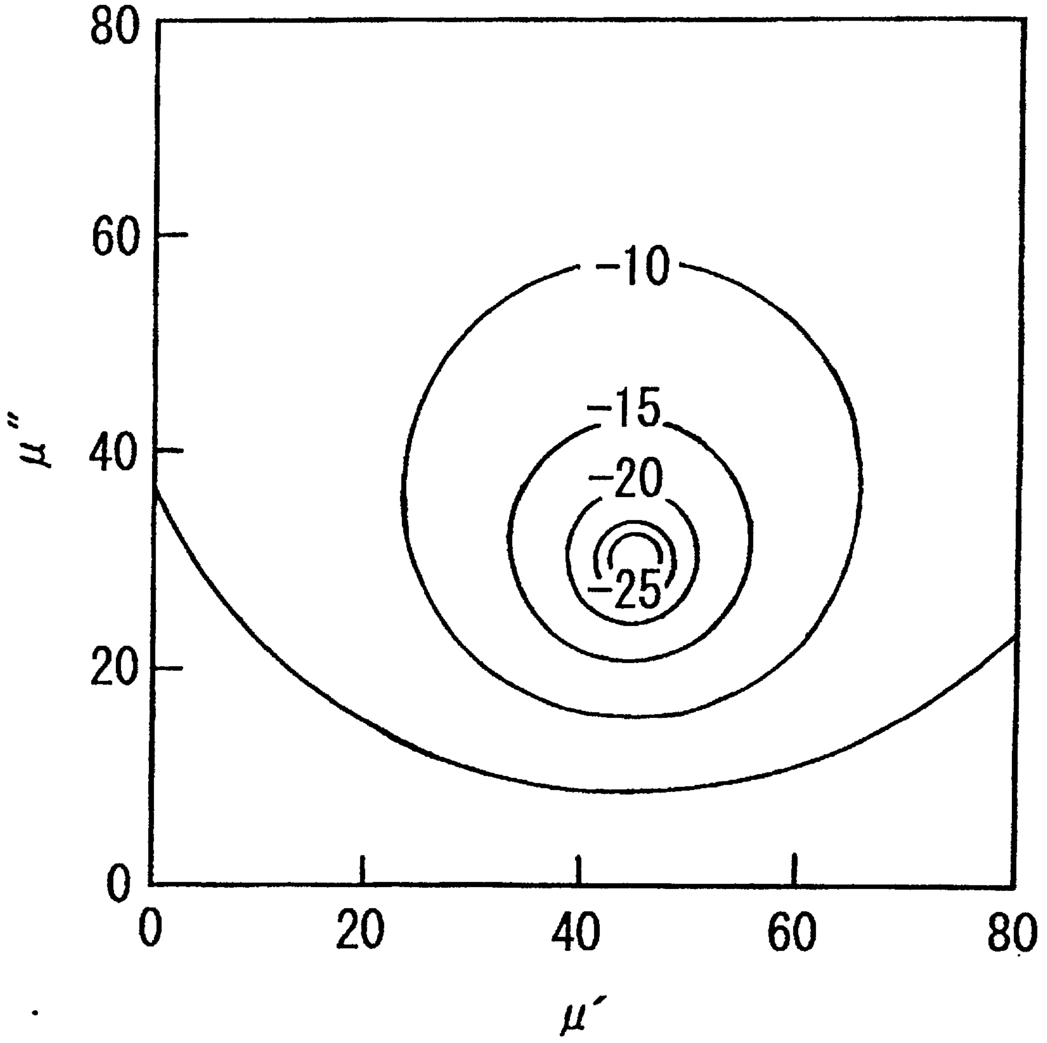

FIG. 6

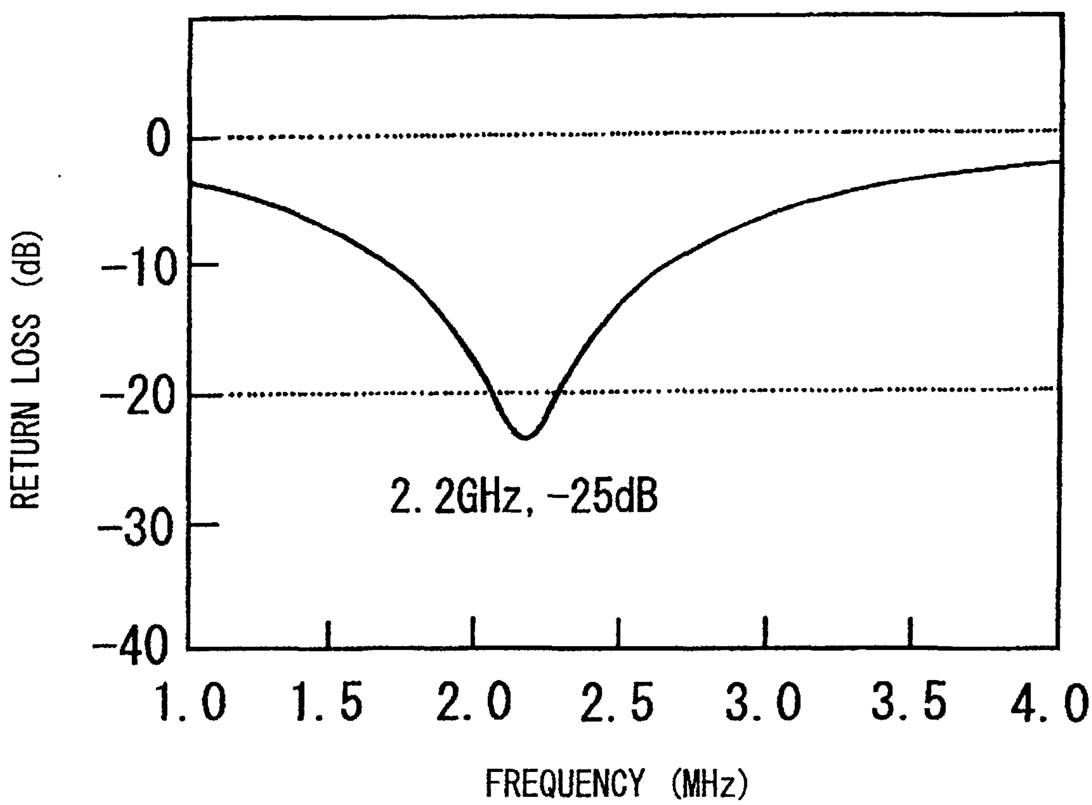
0
-10
-20
-30
-40
RETURN LOSS (dB)
2. 2GHz, -25dB
1. 0
1. 5
2. 0
2. 5
3. 0
3. 5
4. 0
FREQUENCY (MHz)

FIG. 7

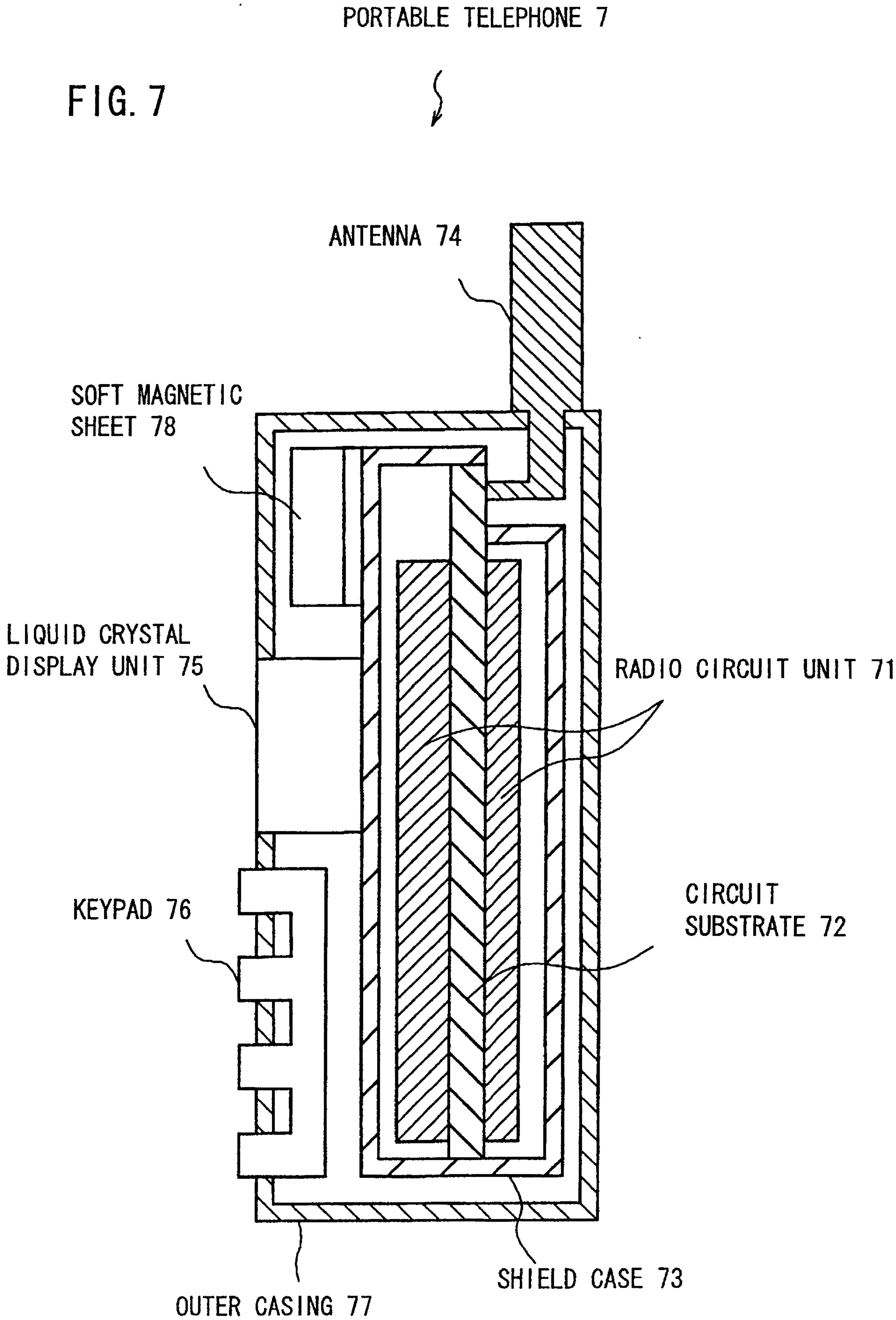
PORTABLE TELEPHONE 7
ANTENNA 74
SOFT MAGNETIC SHEET 78
LIQUID CRYSTAL DISPLAY UNIT 75
RADIO CIRCUIT UNIT 71
CIRCUIT SUBSTRATE 72
KEYPAD 76
SHIELD CASE 73
OUTER CASING 77

FIG. 8

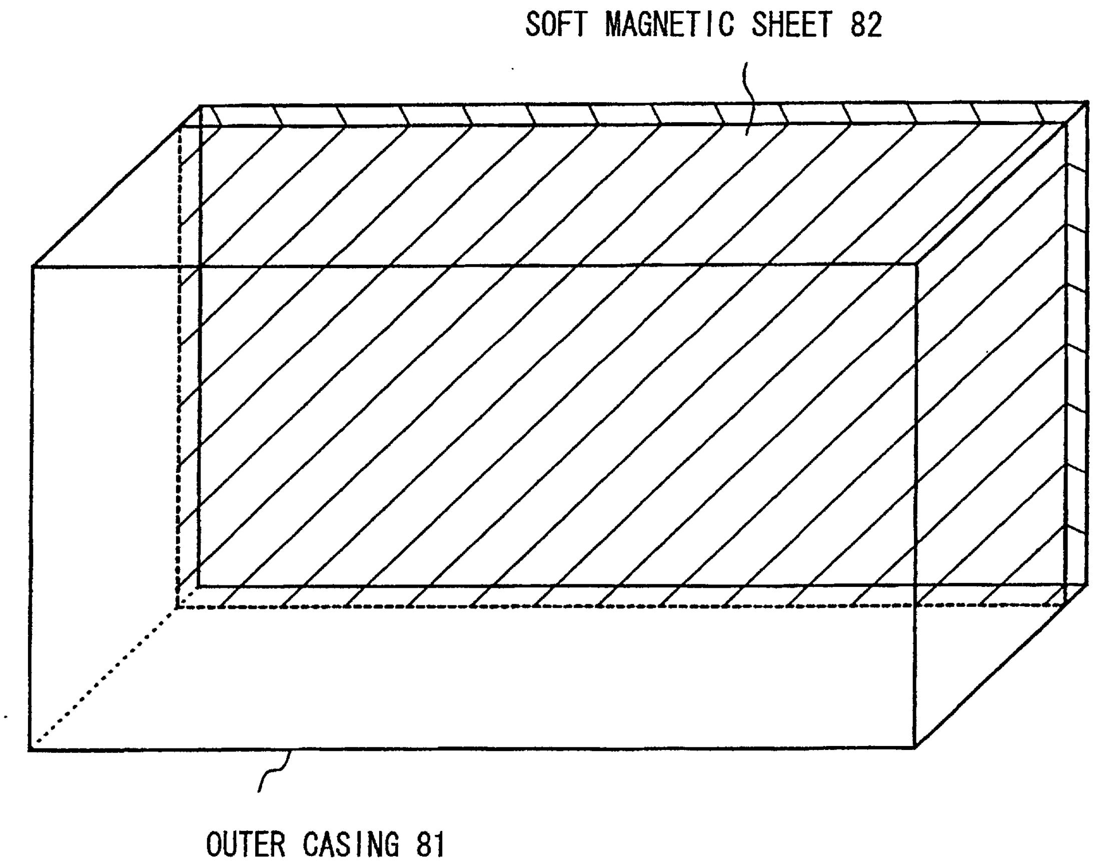

FIG. 9

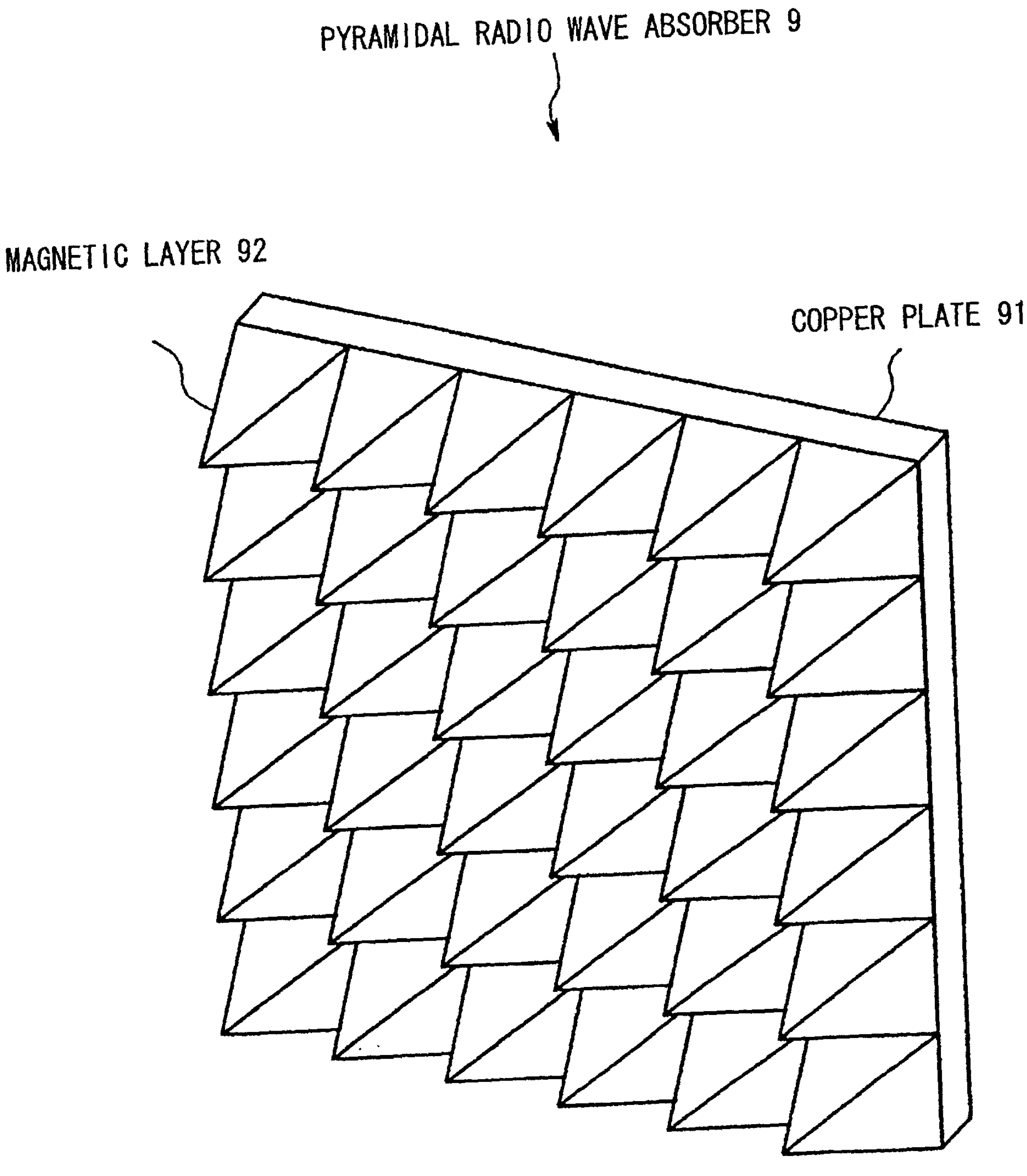
PYRAMIDAL RADIO WAVE ABSORBER 9
MAGNETIC LAYER 92
COPPER PLATE 91

**INTERNATIONAL SEARCH REPORT**

International application No.
PCT/JP01/10058

A. CLASSIFICATION OF SUBJECT MATTER
Int.Cl[7] H05K9/00

According to International Patent Classification (IPC) or to both national classification and IPC

B. FIELDS SEARCHED

Minimum documentation searched (classification system followed by classification symbols)
Int.Cl[7] H05K9/00

Documentation searched other than minimum documentation to the extent that such documents are included in the fields searched
Jitsuyo Shinan Koho 1926-1996 Toroku Jitsuyo Shinan Koho 1994-2001
Kokai Jitsuyo Shinan Koho 1971-2001 Jitsuyo Shinan Toroku Koho 1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 11-177273 A (Nippon Paint Co., Ltd.), 02 July, 1999 (02.07.99), Par.Nos. [0017], [0020], [0031] to [0038], [0042], [0043] (Family: none) | 1-6,8-11<br>7,12,13 |
| X | JP 11-269503 A (Hitachi Metals, Ltd.), 05 October, 1999 (05.10.99), Par. Nos. [0017], [0018] (Family: none) | 1 |
| X | US 5938979 A (Nanogram Corporation), 17 August, 1999 (17.08.99), column 2, lines 3 to 13 & WO 99/23862 A1 & EP 1027819 A1 | 1 |
| Y | JP 2000-307287 A (Tokin Corporation), 02 November, 2000 (02.11.00), Par. No. [0023] (Family: none) | 7 |
| Y | JP 5-179051 A (Hideo OKA), 20 July, 1993 (20.07.93), Par. Nos. [0008] to [0010] (Family: none) | 12 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 November, 2001 (29.11.01) | 11 December, 2001 (11.12.01) |
| Name and mailing address of the ISA/<br>Japanese Patent Office | Authorized officer |
| Facsimile No. | Telephone No. |

Form PCT/ISA/210 (second sheet) (July 1992)

**INTERNATIONAL SEARCH REPORT**

International application No.
PCT/JP01/10058

C (Continuation). DOCUMENTS CONSIDERED TO BE RELEVANT

| Category* | Citation of document, with indication, where appropriate, of the relevant passages | Relevant to claim No. |
|---|---|---|
| Y | JP 10-214717 A (Mitsui Chemicals, Ltd.), 11 August, 1998 (11.08.98), Par. Nos. [0009] to [0011] (Family: none) | 13 |

Form PCT/ISA/210 (continuation of second sheet) (July 1992)